# FASCICULE DE BREVET EUROPEEN

(11) **EP 1 314 202 B1**
(45) Date de publication et mention de la délivrance du brevet: **12.04.2006**
(21) Numéro de dépôt: 01934102.3
(22) Date de dépôt: 11.05.2001
(51) Int. Cl.: H01L 27/146, H01L 31/0352, H01L 31/0232

(54) **DETECTEUR OPTIQUE POLARIMETRIQUE**
OPTISCHER POLARISATIONSEMPFINDLICHTER DETEKTOR
POLARIMETRIC OPTICAL DETECTOR

(30) Priorité: 12.05.2000 FR 0006073
(43) Date de publication de la demande: 28.05.2003
(73) Titulaire: THALES, 92200 Neuilly sur Seine (FR)
(72) Inventeur: BOIS, Philippe, Thomson-CSF Propriété Intellect., F-94117 Arcueil Cedex (FR); COSTARD, Eric, Thomson-CSF Propriété Intellect., F-94117 Arcueil Cedex (FR); AUDIER, Marcel F., Thomson-CSF Propriété Intellect, F-94117 Arcueil Cedex (FR); HERNIOU, Eric, Thomson-CSF Propriété Intellect., F-94117 Arcueil Cedex (FR)
(74) Mandataire: Lucas, Laurent Jacques
(86) Numéro de dépôt international: PCT/FR2001/001439
(87) Numéro de publication internationale: WO 2001/086724

(56) Documents cités:
- EP-A- 0 849 798
- EP-A- 0 849 799
- EP-A- 0 999 600
- US-A- 5 552 603
- CHEN E ET AL: "A NOVEL DEVICE FOR DETECTING THE POLARIZATION DIRECTION OF LINEAR POLARIZED LIGHT USING INTEGRATED SUBWAVELENGTH GRATINGS AND PHOTODETECTORS" IEEE PHOTONICS TECHNOLOGY LETTERS,US,IEEE INC. NEW YORK, vol. 9, no. 9, 1 septembre 1997 (1997-09-01), pages 1259-1261, XP000721228 ISSN: 1041-1135
- SCHABLITSKY S J ET AL: "A wavelength and polarization detector using monolithically integrated subwavelength MSM photodetectors" 1997 55TH ANNUAL DEVICE RESEARCH CONFERENCE DIGEST (CAT. NO.97TH8279), 1997 55TH ANNUAL DEVICE RESEARCH CONFERENCE DIGEST, FORT COLLINS, CO, USA, 23-25 JUNE 1997, pages 168-169, XP002160770 1997, New York, NY, USA, IEEE, USA ISBN: 0-7803-3911-8

## Description

L'invention concerne un détecteur optique polarimétrique permettant de détecter deux polarisations et cela tout en éliminant le bruit de fond.

L'objet de la présente invention est de décrire l'architecture permettant de combiner deux fonctionnalités spécifiques et déjà démontrées des détecteurs à puits quantiques : la possibilité de réaliser des dispositifs bispectraux (brevet français n° 2 756 667) et la possibilité de réaliser des détecteurs intégrant dans la couche active la fonction de soustraction de la composante continue c'est-à-dire le courant d'obscurité d'origine thermique et le courant optique de scène (brevet français n° 2 756 666). Chacune de ces deux fonctions nécessite un double empilement de puits quantiques et une connectique à 3 étages. L'invention permet de conserver ce nombre d'empilements et d'étages de connectiques, tout en permettant la lecture en mode soustractif et selon trois gabarits polarimétriques : vertical (V), horizontal (H) et mixte (V + H).

Chen et al. (Appield Phys. Lett. Fév. 1999, vol.74, 6, 862-864), décrit un détecteur optique polarimétrique infrarouge comportant une structure différente qui consiste en quatre éléments détecteurs actifs à base de puits quantiques ayant un réseau de diffraction différent associé à chaque élément. Le document EP 0 999 600 décrit une structure matricielle intégrée comportant des éléments détecteurs à base de puits quantiques mais ne divulgue pas une structure d'empilement des éléments détecteurs permettant de combiner les deux fonctionnalités. Les documents EP 0 849 798 et EP 0 849 799 décrivent l'architecture d'un détecteur optique bi-fonctionnel à base d'empilement de puits quantiques, mais ces détecteurs ne sont pas spécialement adaptés pour détecter en même temps plusieurs directions de polarisation du rayonnement incident.

L'invention concerne donc un détecteur optique bi-fonctionnel comportant :
- un premier élément détecteur actif à photoconducteur auquel est associé un premier réseau de diffraction permettant de coupler une lumière incidente d'une première direction de polarisation déterminée dans le premier élément détecteur et permettant à celui-ci de détecter la lumière ayant cette première direction de polarisation ;
- un deuxième élément détecteur actif à photoconducteur auquel est associé un deuxième réseau de diffraction permettant de coupler une lumière incidente d'une deuxième direction de polarisation dans le deuxième élément détecteur et permettant à celui-ci de détecter la lumière ayant cette deuxième direction de polarisation.

L'invention concerne aussi un procédé de réalisation d'un tel détecteur.

Les différents objets et caractéristiques de l'invention apparaîtront à la lecture de la description et des figures annexées :
- la figure 1, un exemple de structure d'un détecteur selon l'invention ;
- la figure 2, une vue de dessus de la structure de la figure 1 ;
- la figure 3, une matrice de détecteurs selon l'invention ;
- la figure 4, un tableau de modes de fonctionnement.

L'architecture proposée est identique à celle d'un composant soustractif. La réponse spectrale d'un détecteur à puits quantiques est la convolution de l'absorption spectrale du détecteur et de l'efficacité spectrale induite par la résonance géométrique du réseau de diffraction utilisé pour le couplage optique du rayonnement incident. Ainsi, un réseau de diffraction unidimensionnel résonant autour de λ et orienté selon une direction déterminée (respectivement selon une direction perpendiculaire) couplé à la structure quantique décrite précédemment induira une réponse optique centrée autour de λ et sensible à la lumière incidente polarisée verticalement (respectivement horizontalement).

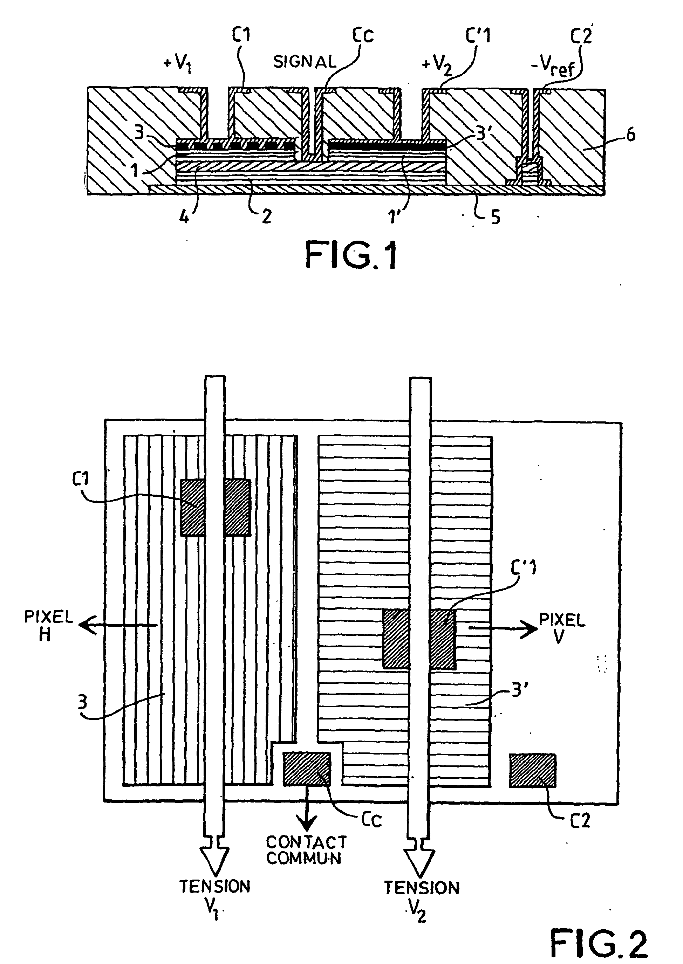

Le principe de l'invention est de séparer le pixel principal de taille a x a en deux sous-pixels de taille a x a/2, chacun de ces sous-pixels étant une structure soustractive classique, mais comportant deux réseaux de couplage différents (figures 1 et figure 2).

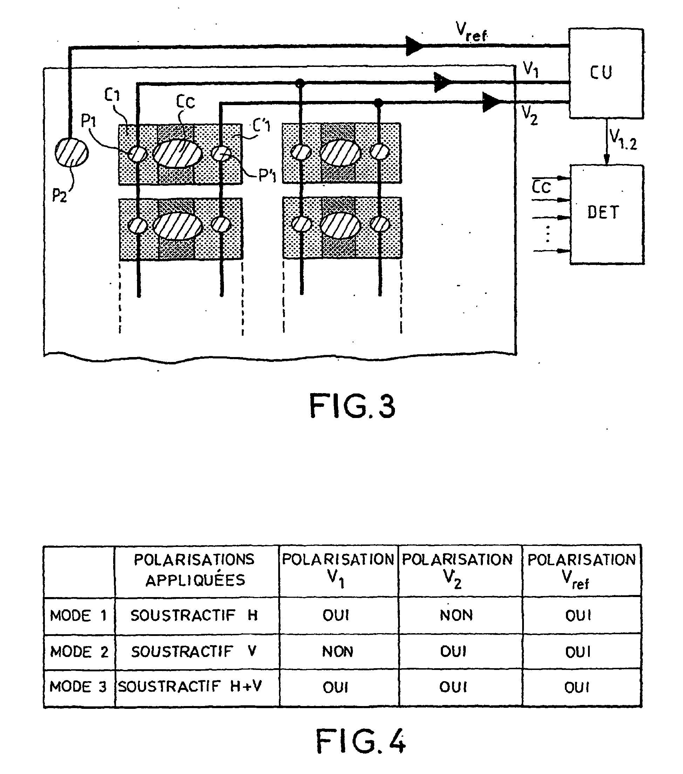

La polarisation de l'étage inférieur Vref, commune à l'ensemble des pixels reste commune aux deux types de sous-pixels. Par contre, la polarisation de l'étage supérieur qui est également commune à l'ensemble des pixels doit être dédoublée, chaque sous-réseau de sous-pixels étant polarisé de manière commune. La connectique de l'étage supérieur est ici assurée par deux lignes de polarisation V₁ et V₂ par pixel au lieu d'une seule pour un pixel soustractif standard comme on le verra avec la figure 4.

Le dispositif peut alors être utilisé en trois modes soustractifs correspondant aux trois modes de polarisations différents V, H et H + V, selon les tensions de polarisation que l'on applique à chacune des électrodes supérieures (figure 4).

Selon un mode de réalisation préférentiel de l'invention, un détecteur optique est réalisé sur un substrat transparent à travers lequel la lumière incidente arrive sur le détecteur. Un tel détecteur optique comporte donc, sur le substrat, une structure telle que représentée à la figure 1. Cette structure comporte sur une face du substrat une première couche de contact ohmique 5, cette couche de contact ohmique étant transparente. Sur cette couche de contact ohmique est situé un empilement de couches 2 constituant un empilement de puits quantiques capable de détecter au moins une gamme de longueurs d'ondes. Sur cet empilement de couches se trouve une deuxième couche de contact ohmique transparente 4. Sur la deuxième couche de contact ohmique se trouvent deux empilements de couches identiques ou quasi-identiques 1, 1' constituant chacun un empilement de puits quantiques capables de détecter au moins une gamme de longueurs d'ondes λ et enfin sur chacun de ces empilements de couches se trouvent des réseaux de diffraction 3 et 3' de structures différentes. Ces réseaux permettent chacun de coupler dans l'empilement de couches (1,1' sur lequel il est réalisé) soit la lumière polarisée selon une direction (verticale par exemple) soit la lumière polarisée perpendiculairement (horizontalement). Pour cela, les deux réseaux sont orientés perpendiculairement (voir figure 2).

Comme représenté en figure 1, l'ensemble est encapsulé dans une couche d'isolant 6 et des moyens de connexion traversent cette couche d'isolant pour atteindre les réseaux de diffraction et réaliser des moyens de connexion C1 et C'1 permettant d'appliquer des tensions +V1 et +V2 respectivement aux réseaux de diffraction 3 et 3'. Egalement, au moins un moyen de connexion traverse la couche d'isolant et atteint la deuxième couche de contact ohmique 4 de façon à réaliser le contact commun Cc permettant la lecture du signal de photoconduction. Et enfin un moyen de connexion C2 est réalisé sur la première couche de contact ohmique 5 de façon à pouvoir appliquer à l'ensemble de la structure la tension -Vref.

La figure 2 représente en vue du dessus un couple d'éléments détecteurs tel que celui de la figure 1. Dans l'exemple de réalisation de la figure 1, l'empilement de couches de puits quantiques 2 constitue en fait deux détecteurs élémentaires, chacun d'eux étant associé à un élément détecteur 1 ou 1' en vue d'éliminer le bruit de fond tel que cela a été expliqué dans le brevet français n° 2 756 666.

Les empilements de couches de puits quantiques 1, 1', 2 sont actifs ou photoconducteurs aux mêmes gammes de longueurs d'ondes λ. Les empilements de couches 1 et 1' sont conçus pour être plus absorbants aux longueurs d'ondes λ que l'empilement de couche 2. L'empilement de couche 2 est de préférence conçu pour n'être quasiment pas absorbant. Cela peut être prévu par des épaisseurs différentes des empilements de couches ou par dopage plus important des couches de puits quantiques des empilements les plus absorbants.

Le détecteur étant éclairé par un rayonnement incident sur la couche de contact ohmique 5, l'empilement de couches 2 reçoit en premier le rayonnement. Celui-ci traverse donc l'empilement de couches 2 puis les empilements de couches 1 et 1' et ils sont couplés par les réseaux de diffraction 3 et 3', selon la polarisation de la lumière dans les empilements de couches 1 et 1'.

Si le réseau de diffraction 3 est prévu pour coupler la lumière polarisée verticalement, la lumière polarisée verticalement sera diffractée vers l'empilement de couche 1 et sera absorbée ou quasiment absorbée par cet empilement de couches. De même, si le réseau de diffraction 3' est prévu pour diffracter la lumière polarisée horizontalement, la lumière polarisée horizontalement sera absorbée ou quasiment absorbée par l'empilement de couche 1'.

La figure 3 représente une réalisation matricielle d'un détecteur selon l'invention. Sur cette figure, on a représenté à titre d'exemple quatre détecteurs optiques tels que décrits précédemment. Chaque détecteur comprend donc deux éléments détecteurs avec chacun son réseau de diffraction. Sur cette figure, on a représenté essentiellement les moyens de connexion permettant de commander de façon matricielle cette matrice de détecteurs. On voit donc sur cette figure 3 que les moyens de connexion C1 sont interconnectés par leur plot P1 vers le potentiel de commande V1. De même, les moyens de connexion C'1 sont interconnectés par leur plot de connexion P'1 au même potentiel de commande V2. La couche de contact commune à laquelle est connectée un plot P2 est connectée au potentiel de référence Vref. Enfin, dans la partie centrale de chaque détecteur est localisé un moyen de connexion Cc permettant de connecter un moyen de mesure de courant individuel pour chaque détecteur.

Sur la figure 3, on a également représenté un circuit de commande CU permettant de délivrer le potentiel de référence Vref et les potentiels de commande V1 et V2.

Un circuit de détection DET reçoit du circuit de commande CU, une information v1.2 indiquant le mode de commande délivré par le circuit CU (potentiels V1 et/ou V2). Il reçoit également les signaux de lecture délivrés par chaque pixel sur son moyen de contact commun Cc.

La figure 4 donne un tableau de commande des détecteurs ainsi réalisés. Ce tableau illustre ainsi la commande des détecteurs par le circuit CU. Comme on peut le voir sur cette figure 4, en mode de fonctionnement un potentiel de référence Vref est appliqué aux différents détecteurs. Lorsqu'on applique un potentiel V1 à un détecteur et qu'on n'applique pas de potentiel V2, ce détecteur permet de détecter la lumière à polarisation horizontale de longueur d'onde λ. Inversement, si on applique un potentiel V2 mais qu'on n'applique pas un potentiel V1 à un détecteur, celui-ci détecte la lumière à polarisation verticale (de longueur d'onde λ). Enfin, si on applique à la fois des potentiels V1 et V2 à un détecteur, il permet de détecter les deux polarisations.

Le mode normal de fonctionnement peut être considéré comme étant le troisième mode et cela pour acquérir le maximum de signal. L'utilisation alternée dans les modes 1 et 2 permet d'ajouter une fonction de polarimétrie. Enfin, en cas d'agression de contre-mesure optique dans une des deux polarisations, on constate que le système peut continuer à fonctionner et à acquérir le signal dans l'autre polarisation.

On va maintenant décrire un exemple de procédé de réalisation d'un détecteur selon l'invention. Pour simplifier la description, on considérera la réalisation d'un détecteur comprenant deux éléments de détection tels que le détecteur de la figure 1 mais l'application de ce procédé pourrait concerner la réalisation d'une matrice de détecteurs.

Ce procédé comporte les étapes suivantes :
- Sur un substrat transparent (non représenté sur la figure 1), on réalise une première couche de contact ohmique 5 transparente aux longueurs d'ondes à détecter.
- Sur cette couche de contact ohmique, on réalise un empilement de puits quantiques permettant d'être photoconducteur à une gamme de longueurs d'ondes λ.
- On réalise ensuite une deuxième couche de contact ohmique transparente aux longueurs d'ondes à détecter.
- Sur cette deuxième couche de contact ohmique on réalise un deuxième empilement de puits quantiques capable d'être photoconducteur à la gamme de longueurs d'ondes λ.
- Sur ce deuxième empilement, on réalise deux réseaux de diffraction orientés perpendiculairement pour diffracter la lumière vers le deuxième empilement de puits quantiques, chacun pour des polarisations différentes.
- Ensuite, par gravure on délimite la géométrie de chaque détecteur. Pour cela, on grave l'ensemble des couches jusqu'à la première couche de contact ohmique 5. On réalise également une saignée entre les deux éléments détecteurs, à la frontière des deux réseaux 3 et 3' de façon à séparer également les empilements de couches 1 et 1' des deux éléments détecteurs.
- Sur l'ensemble ainsi obtenu, on dépose une couche d'isolant 6 d'encapsulation.
- Enfin, on réalise les moyens de connexion. Pour cela, on réalise les trous suivants :
   (a) les trous traversant la couche d'isolant jusqu'aux réseaux de diffraction 3 et 3' que l'on métallise pour former les moyens de connexion C1 et C'1 ;
   (b) le trou de connexion commun traversant la couche d'isolant et le deuxième empilement jusqu'à la deuxième couche de contact ohmique pour former le moyen de connexion commun Cc permettant de le signal de lecture ;
   (c) un trou traversant la couche d'isolant et atteignant la première couche de contact ohmique 5 de façon à réaliser le moyen de connexion C2.

Il est à noter que dans ce qui précède les réseaux de diffraction 3 et 3' peuvent être métallisés pour l'application des potentiels V1 et V2.

Le procédé de l'invention a ainsi permis de réaliser le détecteur de la figure 1. Pour réaliser une matrice de détecteurs, il conviendrait de graver plusieurs détecteurs ainsi conçus sur la première couche de contact ohmique.

## Revendications

1. Détecteur optique polarimétrique comportant :
- une première couche de contact ohmique (5) transparente sur une face d'un substrat transparent,
- un premier empilement de couches (2) constituant des puits quantiques capable de détecter au moins une gamme de longueurs d'onde sur cette couche de contact ohmique,
- une deuxième couche de contact ohmique transparente (4) sur cet empilement de couches (2),
- un deuxième empilement de couches (1) constituant des puits quantiques capable de détecter au moins une gamme de longueurs d'onde, auquel est associé un premier réseau de diffraction (3) permettant de coupler la lumière incidente d'une première direction de polarisation dans le deuxième empilement de couches (1),
- un troisième empilement de couches (1') constituant des puits quantiques capable de détecter au moins une gamme de longueurs d'onde; auquel est associé un deuxième réseau de diffraction (3') orienté perpendiculairement au premier réseau permettant de coupler la lumière incidente d'une seconde direction de polarisation dans le troisième empilement de couches (1'),
- ce deuxième et ce troisième empilement sont situés directement sur la deuxième couche de contact ohmique (4), chaque empitément ayant un moyen de contact (C1, C'1) sur sa face opposée à la deuxième couche de contact ohmique (4),
le deuxième empilement de couches constituant un premier élément détecteur, le troisième empilement de couches constituant un deuxième élément détecteur, la partie du premier empilement de couches située sous le deuxième empilement constituant un troisième élément détecteur et la partie du premier empilement de couches située sous le troisième empilement de couches constituant un quatrième élément détecteur.

2. Détecteur optique selon la revendication 1, **caractérisé en ce que** les empilements de couches constituant les puits quantiques sont similaires et permettent de détecter une même gamme de longueurs d'ondes.

3. Détecteur d'onde optique selon la revendication 1, **caractérisé en ce que** le troisième élément détecteur (2) et le quatrième élément détecteur forment un même élément détecteur.

4. Détecteur optique selon l'une des revendications précédentes, **caractérisé en ce que** les deuxième et troisième empilements de couches (1) et (1') sont conçus pour être sensiblement plus absorbants pour une même gamme de longueurs d'onde que le premier empilement de couches (2).

5. Détecteur optique selon l'une des revendications précédentes, **caractérisé en ce que** les réseaux de diffraction (3, 3') sont en matériau conducteur ou sont revêtus par un matériau conducteur et comportent chacun un premier et un deuxième moyens de contact (C1, C'1) et **en ce que** le détecteur optique comporte également :
- un troisième moyen de contact (Cc) connecté aux faces des différents éléments détecteurs qui sont en contact avec la deuxième couche de contact ohmique (4) ;
- des quatrième moyen de contact (C2) en contact avec les troisième et quatrième éléments détecteurs sur leurs faces communes à la première couche de contact ohmique (5) ;
- des moyens pour appliquer des tensions de commande (+V1, +V2, -Vref) auxdits premier, deuxième et quatrième moyens de contact (C1, C'1, C2) ;
- des moyens de mesure de conduction de courant connectés au troisième moyen de contact (Cc) pour mesurer la photoconduction desdits éléments détecteurs.

6. Détecteur optique selon la revendication 5; **caractérisé en ce qu'**il comporte des moyens de commande permettant d'appliquer une tension de référence (-Vref) au quatrième moyen de contact (C2) ainsi que :
- soit une première tension de commande (+V1) au premier moyen de contact (C1) pour commander le fonctionnement du premier et du troisième éléments détecteurs ;
- soit une deuxième tension de commande (+V2) au deuxième moyen de contact (C'1) pour commander le fonctionnement du deuxième et du quatrième éléments détecteurs ;
- soit les deux tensions (+V1 et +V2) pour commander le fonctionnement de tous les éléments détecteurs.

7. Détecteur selon la revendication 6, **caractérisé en ce qu'**il comporte une matrice d'éléments détecteurs, les quatrième moyens de contact (C2) étant communs à tous les éléments détecteurs de façon à pouvoir appliquer la tension (-Vref) à tous les détecteurs de la matrice, tous les premiers moyens de contact (C1) étant connectés entre eux de façon à appliquer sur demande la première tension de commande (V1) à tous les premiers éléments détecteurs de la matrice, tous les deuxièmes moyens de contact (C'1) étant connectés entre eux de façon à pouvoir appliquer sur demande la deuxième tension de commande (+V2) à tous les deuxièmes éléments détecteurs de la matrice.

8. Procédé de réalisation d'un détecteur optique selon l'une des revendications précédentes, **caractérisé en ce qu'**il comporte les différentes étapes suivantes :
- réalisation sur la face d'un substrat transparent d'une couche de contact ohmique (5) ;
- réalisation sur ladite couche de contact ohmique d'un empilement (2) de couches constituant des puits quantiques permettant la détection d'une gamme de longueurs d'ondes ;
- réalisation sur cet empilement de couches d'une deuxième couche de contact ohmique (4) ;
- réalisation sur la deuxième couche de contact ohmique d'un empilement de couches constituant des puits quantiques permettant la détection d'une gamme de longueurs d'ondes (λ);
- réalisation à la surface du deuxième empilement de couches d'au moins deux réseaux de diffraction (3 et 3') de structures physiques différentes ;
- gravure dans l'ensemble de couches obtenues et jusqu'à atteindre la première couche de contact ohmique (5), d'au moins deux éléments détecteurs, l'un des détecteurs comprenant un réseau de diffraction orienté selon une première direction et l'autre élément détecteur comprenant un réseau de diffraction orienté selon une direction perpendiculaire à la première direction ;
- encapsulation de l'ensemble dans une couche d'isolant (6) ;
- gravure dans la couche d'isolant de trous traversant l'isolant et atteignant les réseaux de diffraction, et métallisation de ces trous de façon à réaliser les premier et deuxième moyens de contact (C1 et C'1);
- réalisation d'au moins un trou par couple d'éléments détecteurs, ledit trou atteignant la deuxième couche de contact ohmique (4) et métallisation de ce trou de façon à réaliser le troisième moyen de contact (Cc) ;
- réalisation d'un trou traversant l'isolant et atteignant la première couche de contact ohmique (5) et métallisation de ce trou de façon à réaliser le quatrième moyen de contact (C2).

## Patentansprüche

1. Optischer polarimetrischer Detektor mit:
- einer ersten transparenten ohmschen Kontaktschicht (5) auf einer Fläche eines transparenten Substrats,
- einem ersten Stapel von Schichten (2), die Quantentröge bilden, die in der Lage sind, mindestens einen Längenwellenbereich auf dieser ohmschen Kontaktschicht zu erfassen,
- einer zweiten transparenten ohmschen Kontaktschicht (4) auf diesem Stapel von Schichten (2),
- einem zweiten Stapel von Schichten (1), die Quantentröge bilden, die in der Lage sind, mindestens einen Längenwellenbereich zu erfassen, dem ein erstes Beugungsgitter (3) zugeordnet ist, das es ermöglicht, das einfallende Licht einer ersten Polarisationsrichtung in dem zweiten Stapel von Schichten (1) zu koppeln,
- einem dritten Stapel von Schichten (1'), die Quantentröge bilden, die in der Lage sind, mindestens einen Längenwellenbereich zu erfassen, dem ein zweites, lotrecht zum ersten Gitter ausgerichtetes Beugungsgitter (3') zugeordnet ist, das es ermöglicht, das einfallende Licht einer zweiten Polarisationsrichtung in dem dritten Stapel von Schichten (1') zu koppeln,
- wobei dieser zweite und dieser dritte Stapel sich direkt auf der zweiten ohmschen Kontaktschicht (4) befinden, wobei jeder Stapel ein Kontaktmittel (C1, C'1) auf seiner der zweiten ohmschen Kontaktschicht (4) entgegengesetzten Fläche hat,
wobei der zweite Stapel von Schichten ein erstes Detektorelement bildet, der dritte Stapel von Schichten ein zweites Detektorelement bildet, der Teil des ersten Stapels von Schichten, der sich unter dem zweiten Stapel befindet, ein drittes Detektorelement bildet, und der Teil des ersten Stapels von Schichten, der sich unter dem dritten Stapel von Schichten befindet, ein viertes Detektorelement bildet.

2. Optischer Detektor nach Anspruch 1, **dadurch gekennzeichnet, dass** die Stapel von Schichten, die die Quantentröge bilden, gleich sind und es ermöglichen, den gleichen Wellenlängenbereich zu erfassen.

3. Optischer Wellendetektor nach Anspruch 1, **dadurch gekennzeichnet, dass** das dritte Detektorelement (2) und das vierte Detektorelement ein einziges Detektorelement bilden.

4. Optischer Detektor nach einem der vorhergehenden Ansprüche, **dadurch gekennzeichnet, dass** der zweite und der dritte Stapel von Schichten (1) und (1') so gestaltet sind, dass sie für den gleichen Wellenlängenbereich wesentlich absorbierender sind als der erste Stapel von Schichten (2).

5. Optischer Detektor nach einem der vorhergehenden Ansprüche, **dadurch gekennzeichnet, dass** die Beugungsgitter (3, 3') aus einem leitenden Material sind oder mit einem leitenden Material bedeckt sind und je ein erstes und ein zweites Kontaktmittel (C1, C'1) aufweisen, und dass der optische Detektor ebenfalls aufweist:
- ein drittes Kontaktmittel (Cc), das mit den Flächen der verschiedenen Detektorelemente verbunden ist, die mit der zweiten ohmschen Kontaktschicht (4) in Kontakt sind;
- vierte Kontaktmittel (C2) in Kontakt mit den dritten und vierten Detektorelementen auf ihren der ersten ohmschen Kontaktschicht (5) gemeinsamen Flächen;
- Mittel, um Steuerspannungen (+V1, +V2, -Vref) an die ersten, zweiten und vierten Kontaktmittel (C1, C'1, C2) anzulegen;
- Stromleitungsmessmittel, die mit dem dritten Kontaktmittel (Cc) verbunden sind, um die Photoleitung der Detektorelemente zu messen.

6. Optischer Detektor nach Anspruch 5, **dadurch gekennzeichnet, dass** er Steuermittel aufweist, die es ermöglichen, eine Bezugsspannung (-Vref) an das vierte Kontaktmittel (C2) anzulegen, sowie:
- entweder eine erste Steuerspannung (+V1) an das erste Kontaktmittel (C1) anzulegen, um den Betrieb des ersten und des dritten Detektorelements zu steuern;
- oder eine zweite Steuerspannung (+V2) an das zweite Kontaktmittel (C'1) anzulegen, um den Betrieb des zweiten und des vierten Detektorelements zu steuern;
- oder die beiden Spannungen (+V1 und +V2) anzulegen, um den Betrieb aller Detektorelemente zu steuern.

7. Detektor nach Anspruch 6, **dadurch gekennzeichnet, dass** er eine Matrix von Detektorelementen aufweist, wobei die vierten Kontaktmittel (C2) allen Detektorelementen gemeinsam sind, um die Spannung (-Vref) an alle Detektoren der Matrix anlegen zu können, wobei alle ersten Kontaktmittel (C1) miteinander verbunden sind, um auf Anforderung die erste Steuerspannung (+V1) an alle ersten Detektorelemente der Matrix anlegen zu können, wobei alle zweiten Kontaktmittel (C'1) miteinander verbunden sind, um auf Anforderung die zweite Steuerspannung (+V2) an alle zweiten Detektorelemente der Matrix anlegen zu können.

8. Verfahren zur Herstellung eines optischen Detektors nach einem der vorhergehenden Ansprüche, **dadurch gekennzeichnet, dass** es die folgenden verschiedenen Schritte aufweist:
- Herstellung einer ohmschen Kontaktschicht (5) auf der Fläche eines transparenten Substrats;
- Herstellung eines Stapels (2) von Schichten auf der ohmschen Kontaktschicht, die Quantentröge bilden, welche die Erfassung eines Wellenlängenbereichs erlauben;
- Herstellung einer zweiten ohmschen Kontaktschicht (4) auf diesem Stapel von Schichten;
- Herstellung eines Stapels von Schichten auf der zweiten ohmschen Kontaktschicht, die Quantentröge bilden, die die Erfassung eines Wellenlängenbereichs (λ) erlauben;
- Herstellung von mindestens zwei Beugungsgittern (3 und 3') mit unterschiedlichen physikalischen Strukturen an der Oberfläche des zweiten Stapels von Schichten;
- Gravieren in die Einheit von erhaltenen Schichten und bis zum Erreichen der ersten ohmschen Kontaktschicht (5) von mindestens zwei Detektorelementen, wobei einer der Detektoren ein Beugungsgitter aufweist, das gemäß einer ersten Richtung ausgerichtet ist, und das andere Detektorelement ein Beugungsgitter aufweist, das gemäß einer Richtung lotrecht zur ersten Richtung ausgerichtet ist;
- Einkapselung der Einheit in einer Isolierschicht (6);
- Gravieren in die Isolierschicht von Löchern, die die Isolierung durchqueren und die Beugungsgitter erreichen, und Metallbeschichtung dieser Löcher, um die ersten und zweiten Kontaktmittel (C1 und C'1) herzustellen;
- Herstellung mindestens eines Lochs für jedes Paar von Detektorelementen, wobei das Loch die zweite ohmsche Kontaktschicht (4) erreicht, und Metallbeschichtung dieses Lochs, um das dritte Kontaktmittel (Cc) herzustellen;
- Herstellung eines Lochs, das die Isolierung durchquert und die erste ohmsche Kontaktschicht (5) erreicht, und Metallbeschichtung dieses Lochs, um das vierte Kontaktmittel (C2) herzustellen.

## Claims

1. Optical polarimetric detector comprising:
- a first transparent ohmic contact layer (5) on one face of a transparent substrate,
- a first stack of layers (2) forming quantum wells capable of detecting at least one range of wavelengths on this ohmic contact layer,
- a second transparent ohmic contact layer (4) on this stack of layers (2),
- a second stack of layers (1) forming quantum wells capable of detecting at least one range of wavelengths, with which a first diffraction grating (3) is associated allowing incident light from a first polarization direction to be coupled in the second stack of layers (1),
- a third stack of layers (1') forming quantum wells capable of detecting at least one range of wavelengths, with which a second diffraction grating (3'), oriented perpendicularly to the first grating, is associated allowing incident light from a second polarization direction to be coupled in the third stack of layers (1'),
- this second and this third stack are located directly on the second ohmic contact layer (4), each stack having a contact means (C1, C'1) on its face opposite the second ohmic contact layer (4),
the second stack of layers forming a first detector element, the third stack of layers forming a second detector element, the part of the first stack of layers located under the second stack forming a third detector element and the part of the first stack of layers located under the third stack of layers forming a fourth detector element.

2. Optical detector according to Claim 1, **characterized in that** the stacks of layers forming quantum wells are similar and allow the same range of wavelengths to be detected.

3. Optical wave detector according to Claim 1, **characterized in that** the third detector element (2) and the fourth detector element form one and the same detector element.

4. Optical detector according to one of the preceding claims, **characterized in that** the second and third stacks of layers (1) and (1') are designed to be substantially more absorbing for one and the same range of wavelengths than the first stack of layers (2).

5. Optical detector according to one of the preceding claims, **characterized in that** the diffraction gratings (3, 3') are made of a conducting material or are coated by a conducting material and each one comprises a first and a second contact means (C1, C'1) and **in that** the optical detector also comprises:
- a third contact means (Cc) connected to the faces of the various detector elements which are in contact with the second ohmic contact layer (4);
- fourth contact means (C2) in contact with the third and fourth detector elements on their faces away from the first ohmic contact layer (5);
- means for applying control voltages (+V1, +V2, -Vref) to said first, second and fourth contact means (C1, C'1, C2);
- current conduction measuring means connected to the third contact means (Cc) for measuring the photoconduction of said detector elements.

6. Optical detector according to Claim 5, **characterized in that** it comprises control means making it possible to apply a reference voltage (-Vref) to the fourth contact means (C2) together with:
- either a first control voltage (+V1) to the first contact means (C1) in order to control the operation of the first and third detector elements;
- or a second control voltage (+V2) to the second contact means (C'1) in order to control the operation of the second and fourth detector elements;
- or both voltages (+V1 and +V2) in order to control the operation of all the detector elements.

7. Detector according to Claim 6, **characterized in that** it comprises a matrix of detector elements, the fourth contact means (C2) being common to all the detector elements so as to be able to apply the voltage (-Vref) to all the detectors of the matrix, all the first contact means (C1) being connected together so as to apply, on demand, the first control voltage (+V1) to all the first detector elements of the matrix, all the second contact means (C'1) being connected together so as to be able to apply, on demand, the second control voltage (+V2) to all the second detector elements of the matrix.

8. Method of producing an optical detector according to one of the preceding claims, **characterized in that** it comprises the following various steps:
- producing an ohmic contact layer (5) on the face of a transparent substrate;
- producing a stack (2) of layers forming quantum wells allowing a range of wavelengths to be detected, on said ohmic contact layer;
- producing a second omhic contact layer (4) on this stack of layers;
- producing a stack of layers forming quantum wells allowing a range of wavelengths (λ) to be detected, on the second ohmic contact layer;
- producing layers of at least two diffraction gratings (3 and 3') having different physical structures, on the surface of the second stack of layers;
- etching at least two detector elements in the assembly of layers obtained until reaching the first ohmic contact layer (5), one of the detectors having a diffraction grating oriented in a first direction and the other detector element having a diffraction grating oriented in a direction perpendicular to the first direction;
- encapsulation of the assembly in an insulating layer (6);
- etching holes in the insulating layer, which pass through the insulator and reach the diffraction gratings, and metallizing these holes so as to produce the first and second contact means (C1 and C'1);
- producing at least one hole per pair of detector elements, said hole reaching the second ohmic contact layer (4), and metallizing this hole so as to produce the third contact means (Cc);
- producing a hole passing through the insulator and reaching the first ohmic contact layer (5) and metallizing this hole so as to produce the fourth contact means (C2).
